# EUROPÄISCHE PATENTANMELDUNG

(11) **EP 0 892 425 A2**
(43) Veröffentlichungstag der Anmeldung: **20.01.1999**
(21) Anmeldenummer: 98105612.0
(22) Anmeldetag: 27.03.1998
(51) Int. Cl.: H01L 21/3205, H01L 21/768

(54) **Herstellverfahren für eine Platinmetall-Struktur mittels eines Lift-off-Prozesses**

(30) Priorität: 24.04.1997 DE 19717363
(71) Anmelder: SIEMENS AKTIENGESELLSCHAFT, 80333 München (DE)
(72) Erfinder: Schindler, Günther, Dr., 80802 München (DE); Hartner, Walter, 81829 München (DE); Pitzer, Dana, 85716 Unterschleissheim (DE)

(57) **Zusammenfassung**

Das Herstellverfahren beinhaltet für die Strukturierung des Platinmetalls ein Lift-off-Verfahren, bei dem die Maske eine Siliziumoxidschicht enthält. Durch die Verwendung von Siliziumoxid kann eine erforderliche negative Flanke der Maske erzielt werden und die Maske kann einfach entfernt werden. Das Verfahren kann bei der Herstellung von DRAMs mit einem hoch-ε-Dielektrikum und FRAM's eingesetzt werden.

## Beschreibung

Die Erfindung betrifft ein Herstellverfahren für eine Platinmetall-Struktur auf einem Substrat, insbesondere bei der Herstellung einer integrierten Schaltung.

In der Halbleitertechnologie wird die Verwendung von Platinmetallen als leitenden Materialien zunehmend interessant. Unter 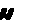 Platinmetall" ist dabei die Gruppe der Platinmetalle zu verstehen, also Pt, Ir, Ru etc. Als Edelmetalle besitzen sie eine hohe Leitfähigkeit und bilden auch bei hohen Temperaturen in einer sauerstoffhaltigen Atmosphäre keine nichtleitenden Oxide. Ferner weisen sie gute Grenzflächeneigenschaften sowohl in mechanischer als auch in elektrischer Hinsicht bezüglich vielen in der Halbleitertechnologie verwendeten Substanzen auf. Ein wichtiges Einsatzgebiet von Platinmetallen ist die Verwendung als Elektrodenmaterial bei Speicherkondensatoren in integrierten DRAM-Speichern, insbesondere, wenn diese ein sogenanntes Hoch-ε-Dielektrikum (beispielsweise BST) oder ein Ferroelektrikum als Speicherdielektrikum aufweisen. Die Herstellung dieser Speicherdielektrika erfordert nämlich hohe Temperaturen in einer oxidierenden Atmosphäre. Derartige Speicherzellen weisen einen geringen Platzbedarf auf und sind für zukünftige Speichergenerationen sehr interessant.

Ein Nachteil der Platinmetalle ist, daß sie schwer ätzbar sind. Bisherige Verfahren beruhen auf überwiegend physikalischer Ätzung, beispielsweise Ion Milling und besitzen daher nur geringe Selektivität gegenüber anderen Materialien, wie beispielsweise Fotolack. Für größere Strukturen wurden auch bereits Lift-off-Verfahren mit einer Maske aus Fotolack oder Titan verwendet.

Bei einem Lift-off-Verfahren wird bekanntermaßen unter der zu strukturierenden Schicht eine Maske auf ein Substrat aufgebracht, die an den Stellen der zu erzeugenden Struktur eine Öffnung enthalt. Lediglich der auf der Maske aufliegende Teil der Schicht wird dann zusammen mit der Maske entfernt. Dabei ist wichtig, daß die Maske am Rand der Öffnung eine negative Flanke aufweist, die freiliegende Substratoberfläche also größer ist als die Maskenöffnung an der Oberseite der Maske. Mit anderen Worten, die Maske muß in irgendeiner Form überhängend sein. Dadurch wird die Flanke nicht beschichtet und das Lösungsmittel für die Maske kann an dieser Stelle angreifen. Bei Verwendung von Fotolack als Maske in einem Lift-off-Verfahren sind diese negativen Flanken nur mit für die Halbleiterfertigung unüblichen Spezialverfahren (beispielsweise Image-Reversal) zu erreichen. Bei Verwendung von Titan als Maske spielt der Zeitfaktor eine wichtige Rolle, da Titan bei Kontakt mit Luft leicht an der Oberfläche oxidiert und dann schlecht zu entfernen ist.

Die Erfindung hat zur Aufgabe, ein einfaches Herstellverfahren für eine Struktur aus einem Platinmetall anzugeben. Das Herstellverfahren soll ferner in den Herstellprozeß einer DRAM-Speicherzelle integrierbar sein.

Diese Aufgabe wird durch ein Verfahren mit den Merkmalen des Patentanspruchs 1 und durch ein Verfahren mit den Merkmalen des Patentanspruchs 2 gelöst.

Die Erfindung beruht auf der Verwendung von Siliziumoxid als Bestandteil einer Maske für einen Lift-off-Prozeß. Dabei wird die erforderliche negative Flanke der Maske gemäß einer ersten Ausführungsform durch einen Ätzprozeß erzielt, insbesondere durch eine Kombination von einem anisotropen und einem isotropen Ätzprozeß. Gemäß einer zweiten Ausführungsform wird auf die Siliziumoxid-Schicht eine Siliziumschicht aufgebracht und nach der Strukturierung dieser Doppelschicht entsprechend der herzustellenden Maske eine Oxidation der Siliziumschicht durchgeführt; die dabei auftretende Volumenvergrößerung der Siliziumschicht führt zu einem Überhang über die Siliziumoxid-Schicht. Nach der Beschichtung mit dem Platinmetall kann die Siliziumoxid-Maske sehr einfach, beispielsweise mit HF, entfernt werden.

Das Verfahren ist problemlos in den dem Herstellprozeß einer DRAM-Speicherzelle integrierbar, bei dem eine Elektrode des Speicherkondensators aus einem Platinmetall hergestellt wird.

Auf das Substrat, auf das die Maske aufgebracht wird, kann vor der Siliziumoxid-Schicht eine Ätzstopschicht beispielsweise aus Siliziumnitrid aufgebracht werden, um es bei der Entfernung der Maske zu schützen. Als Platinmetall wird bevorzugt Pt oder Ir verwendet.

Die Erfindung wird im folgenden anhand von Ausführungsbeispielen, die in den Figuren dargestellt sind, näher erläutert. Es zeigen:
FIG 1 bis 4 einen Querschnitt durch ein Substrat, an dem die Schritte des Verfahrens gemäß einer ersten Ausführungsform verdeutlicht werden,
FIG 5 bis 7 die wesentlichen Schritte eines zweiten Ausführungsbeispiels.

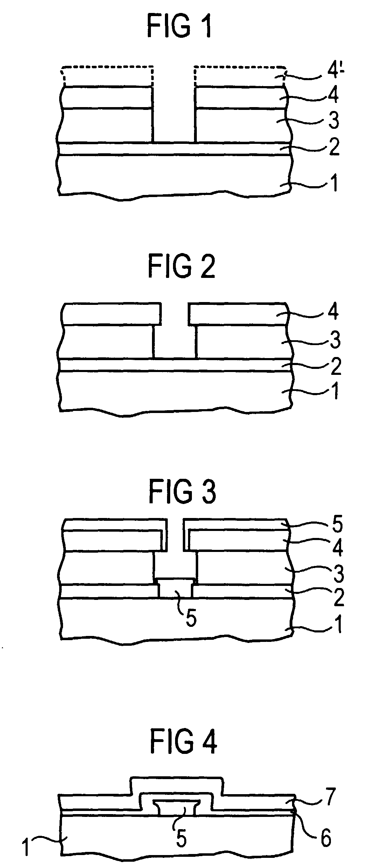

FIG 1: Auf ein Substrat 1 werden eine bspw. aus Nitrid bestehende Ätzstopschicht 2, eine Siliziumoxid-Schicht 3 und eine Maskenschicht 4 mit bekannten Verfahren aufgebracht. Die Dicken der Schichten 2 und 3 können bspw. 20 nm und 50 nm betragen. Das Substrat kann bereits fertiggestellte Schaltungselemente enthalten, beispielsweise einen elektrischen Anschluß für die herzustellende Platinstruktur. Die optionale Ätzstopschicht besteht vorzugsweise aus Siliziumnitrid. Die Maskenschicht 4 kann entweder eine Fotolackschicht sein, die entsprechend der herzustellenden Platinstruktur belichtet und entwickelt wird, so daß sie im Bereich der herzustellenden Platinstruktur eine Öffnung aufweist. Sie kann aber auch eine sog. Hartmaske sein, die bspw. aus Siliziumnitrid besteht, und die mit Hilfe einer entsprechend strukturierten zusätzlichen Fotomaske 4' (gestrichelt dargestellt) erzeugt wird. Für die weiteren Schritte wird dann die Hartmaske 4 nach Entfernung der Lackmaske 4' als Maske 4 verwendet. Bei dieser Variante ergibt sich der Vorteil, daß das Platinmetall auch heiß gesputtert werden kann. Mit der Maske 4 wird die Siliziumoxid-Schicht 3 geätzt. In diesem Ausführungsbeispiel wird die Oxidschicht 3 zunächst anisotrop bis zur Ätzstopschicht 2 geätzt.

FIG 2: Anschließend erfolgt eine isotrope Ätzung der Siliziumoxid-Schicht selektiv zur Ätzstopschicht 2, beispielsweise in einem Naßätzschritt. Dadurch hängt die Maske 4 über den Rand der Siliziumoxidmaske 3 über, die Gesamtstruktur besitzt also eine negative Flanke.

FIG 3: Die freiliegende Ätzstopschicht wird entfernt, so daß das Substrat - ggf. mit einer Anschlußstruktur für die Platinstruktur - freiliegt. Auf diese Anordnung wird ganzflächig ein Platinmetall 5, vorzugsweise Pt aufgebracht, beispielsweise durch einen Sputterprozeß. Die Flanken der Siliziumoxid-Maske 3 werden dabei nicht beschichtet, so daß im nachfolgenden Siliziumoxid-Naßätzprozeß das Lösungsmittel an diesen Stellen angreifen kann und das auf der Maskenoberfläche aufliegende Platin mit entfernt wird.

FIG 4: Nach Durchführung des Siliziumoxid-Ätzprozesses verbleibt lediglich das die Platinstruktur bildende Platin auf der Substratoberfläche. Ein Speicherkondensator kann durch Aufbringen eines Speicherdielektrikums 6, insbesondere eines hoch-ε-Dielektrikums oder eines Ferroelektrikums wie oben erläutert, und anschließenden Herstellen einer zweiten Kondensatorelektrode 7 (beispielsweise ebenfalls aus Platin) fertiggestellt werden.

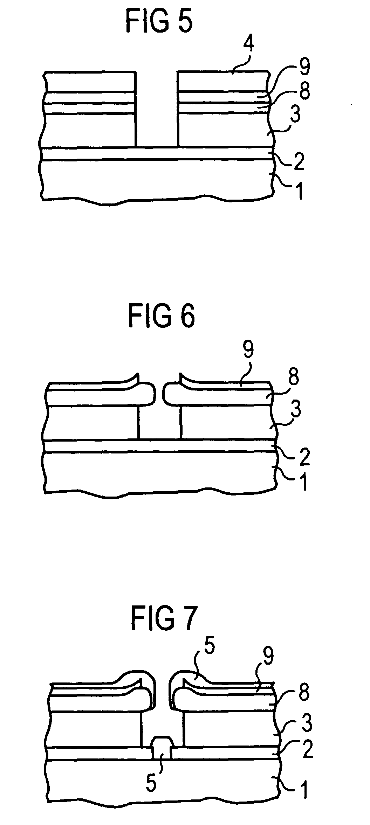

FIG 5: Im zweiten Ausführungsbeispiel wird wie beim ersten Ausführungsbeispiel zunächst vorzugsweise eine Ätzstopschicht 2 auf das Substrat 1 aufgebracht. Darüber wird eine Doppelschicht aus Siliziumoxid 3 und Polysilizium 8 abgeschieden. Anschließend kann eine Oxidationsschutzschicht 9, insbesondere eine Nitridschicht, abgeschieden werden. Die Schichtenfolge 3, 8, 9 wird dann mit Hilfe einer Fotomaske 4, die an der Stelle der herzustellenden Platinstruktur eine Öffnung aufweist, bis zur Ätzstopschicht 2 anisotrop geätzt. Die Lackmaske 4 kann anschließend entfernt werden.

FIG 6: Es wird eine thermische Oxidation durchgeführt, die das Polysilizium an den freiliegenden Stellen unter Volumenvergrößerung in Siliziumoxid umwandelt. Dadurch wird die Öffnung in der Polysiliziumschicht 8 verkleinert und es entsteht ein Überhang über die Siliziumoxidstruktur. Die Maske für den Lift-off-Prozeß besteht hier also aus der Siliziumoxidschicht und der Polysiliziumschicht (sowie ggf. der Nitridschicht). Die optionale Oxidationsschutzschicht 9 bewirkt einen größeren Überhang, da dann das Polysilizium 8 nur an den freiliegenden Kanten oxidieren kann. Bei diesem Ausführungsbeispiel muß in jedem Fall beim Layout berücksichtigt werden, daß aufgrund der Oxidation die Öffnung gegenüber der ursprünglichen Lackmaske 4 verkleinert wird.

FIG 7: Das weiter Verfahren kann hier im ersten Ausführungsbeispiel durchgeführt werden, d.h. es wird die Ätzstopschicht 2 entfernt, dann ein Platinmetall aufgebracht und das auf der Maskenoberfläche aufliegende Platinmetall gemeinsam mit der Maske entfernt. Wie erläutert, kann anschließend ein Kondensator fertiggestellt werden.

## Patentansprüche

1. Herstellverfahren für eine Platinmetall-Struktur auf einem Substrat mit folgenden Schritten:
a) Aufbringen einer Siliziumoxid-Schicht(3) auf dem Substrat (1)
b) Aufbringen einer Maske (4) auf der Siliziumoxidschicht (3), die an der Stelle der herzustellenden Platinmetall-Struktur eine Öffnung aufweist,
c) Ätzen der Siliziumoxid-Schicht (3) derart, daß die freigelegte Substratoberfläche größer ist als die Öffnung in der Maske (4),
d) Aufbringen einer Platinmetallschicht (5) auf der Maske (4) und der freigelegten Substratoberfläche (1),
e) Entfernen der Siliziumoxidschicht (3) in einem Ätzprozeß, so daß das auf der Maske (4) vorhandene Platinmetall (5) mit entfernt wird und das auf der Substratoberfläche vorhandene Platinmetall (5) die Platinmetall-Struktur bildet.

2. Verfahren nach Anspruch 1, bei dem Schritt c) einen anisotropen und einen darauffolgenden isotropen Ätzprozeß beinhaltet.

3. Verfahren nach einem der Ansprüche 1 und 2, bei dem als Maske (4) eine Hartmaske erzeugt wird.

4. Herstellverfahren für eine Platinmetall-Struktur auf einem Substrat (1) mit folgenden Schritten:
a) Aufbringen einer Siliziumoxid-Schicht (3) und einer darüberliegenden Siliziumschicht (8) auf dem Substrat (,1),
b) Aufbringen einer Fotomaske (4) auf der Siliziumschicht (8), die an der Stelle der herzustellenden Platinmetallstruktur eine Öffnung aufweist,
c) Ätzen der Siliziumschicht (8) und der Siliziumoxidschicht (3), und Oxidieren der freiliegenden Oberfläche der Siliziumschicht (8),
d) Aufbringen einer Platinmetallschicht (5) auf der Maskenoberfläche und der freigelegten Substratoberfläche,
e) Entfernen der Siliziumoxid-Schicht (3) in einem Ätzprozeß, so daß das auf der Maskenoberfläche vorhandene Platinmetall (5) mit entfernt wird und das auf der Substratoberfläche vorhandene Platinmetall die Platinmetall-Struktur ergibt.

5. Verfahren nach einem der Ansprüche 1 bis 4, bei dem vor Schritt a) eine Ätzstopschicht (2) auf dem Substrat (1) aufgebracht wird, die vor Schritt d) innerhalb der Öffnung wieder entfernt wird.

6. Verfahren nach Anspruch 5, bei dem in Schritt c) die Oberfläche der Ätzstopschicht (2) freigelegt wird und anschließend die Ätzstopschicht (2) anisotrop oder isotrop geätzt wird.

7. Verfahren nach einem der Ansprüche 1 bis 6, bei dem die Siliziumoxidschicht in Schritt e) mit HF entfernt wird.

8. Verfahren nach einem der Ansprüche 4 bis 7, bei dem auf die Siliziumschicht (8) in Schritt a) eine Oxidationsschutzschicht (9) aufgebracht wird.

9. Verwendung des Verfahrens nach einem der Ansprüche 1 bis 8 bei der Herstellung einer Kondensatorelektrode.
